(19) Europäisches Patentamt
European Patent Office
Office européen des brevets

(11) Veröffentlichungsnummer: **0 195 332**
**B1**

(12) # EUROPÄISCHE PATENTSCHRIFT

(45) Veröffentlichungstag der Patentschrift: **28.06.89**

(51) Int. Cl.⁴: **H05K 1/00**, H05K 3/38, H05K 3/18

(21) Anmeldenummer: **86103104.5**

(22) Anmeldetag: **08.03.86**

(54) **Elektrische Leiterplatten.**

(30) Priorität: **21.03.85 DE 3510202**

(43) Veroffentlichungstag der Anmeldung
**24.09.86 Patentblatt 86/39**

(45) Bekanntmachung des Hinweises auf die Patenterteilung:
**28.06.89 Patentblatt 89/26**

(84) Benannte Vertragsstaaten:
**AT BE CH DE FR GB IT LI NL SE**

(56) Entgegenhaltungen:
**EP-A- 0 053 279**
**EP-A- 0 081 129**
**DE-A- 1 496 748**
**DE-A- 2 320 099**
**GB-A- 1 337 338**
**US-A- 3 560 257**

**NEW ELECTRONICS, Band 8, Nr. 6, 18 März 1975, Seiten 45,46,48, Juniper Journals Ltd., London, GB; M.J.AGGLETON et al.: "Semi- and fully- additive printed circuitry"**

**Die Akte enthält technische Angaben, die nach dem Eingang der Anmeldung eingereicht wurden und die nicht in dieser Patentschrift enthalten sind.**

(73) Patentinhaber: **BAYER AG,**
**D-5090 Leverkusen 1 Bayerwerk(DE)**

(72) Erfinder: **Sirinyan, Kirkor, Dr., Humperdinckstrasse 12, D-5060 Bergisch Gladbach 2(DE)**
Erfinder: **Wolf, Gerhard Dieter, Dr., Wilhelm-Busch-Strasse 29, D-4047 Dormagen 5(DE)**
Erfinder: **von Gizycki, Ulrich, Dr., Wiembachallee 24, D-5090 Leverkusen 3(DE)**
Erfinder: **Merten, Rudolf, Dr., Berta-von-Suttner-Strasse 55, D-5090 Leverkusen(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

## Beschreibung

Es ist allgemein bekannt, daß man zur Herstellung von elektrischen Leiterplatten in metallkaschierten oder metallaminierten Isolierbasismaterialien Bohrungen anbringt, die Bohrlöcher auf chemischem Wege durchkontaktiert, die Substratoberfläche mit einer Maske bedeckt, die freie Metalloberfläche auf galvanischem Wege mit einem ätzmittelbeständigen Metallresist versieht, die Maske in einem geeigneten Medium von der Substratoberfläche entfernt und dann die Grundmetallschicht wegätzt. Die zur Durchführung dieses Verfahrens (Subtraktiv-Verfahren) eingesetzten Metallauflagen bestehen in den meisten Fällen aus reinem Elektrolytkupfer und haben eine Schichtdicke von 17,5 bis 70 µm.

Die bekannten Subtraktiv-Verfahren haben nicht nur den Nachteil, daß sie aus mehreren Teilschritten bestehen, sondern sie führen im letzten Schritt zur Unterätzung der Leiterbahnen.

Ein weiterer Nachteil der bekannten Verfahren besteht darin, daß sie Metallresists erfordern.

Beim Aufbringen der Metallresistauflage kann das galvanisch aufwachsende Metallresist auch seitlich "auswuchern". Man spricht von "Überplattierung" oder auch "Pilzbildung" der Leiterbahnen, was sich auf die im Querschnitt zu sehende pilzähnliche Form und die geringe Tiefenschärfe bezieht. Dieser unerwünschte Effekt wird durch das nachfolgende Wegätzen der Grundkupferschicht noch weiter verstärkt. Um die besagte "Überplattierung" oder "Pilzbildung" zu vermeiden, müssen mechanisch stabile und dicke Folienresiste verwendet werden.

Solche mechanisch stabilen Folienresiste sollen sowohl die Kupferleiter als auch das Resistmetall "kanalisieren" und somit die Pilzbildung vermeiden.

Ein weiterer sehr großer Nachteil der Metallresiste besteht darin, daß sie beim Löten schmelzen und zum bekannten Apfelsinenhauteffekt führen. Besonders bei hochwertigen Leiterplatten kann dieser Effekt nicht akzeptiert werden. Als weiterer Nachteil des Subtraktivverfahrens sei erwähnt, daß es zur Herstellung von Feinleiterplatten mit einer Leiterbahnbreite von $\leq$ 100 µm aus den genannten Gründen nicht geeignet ist.

Um die angegebenen Nachteile zu vermeiden, wurde bereits versucht, die sogenannten Semiadditiv- und Volladditiv-Verfahren zu entwickeln. Zur Durchführung dieser Verfahren ist das Aufbringen einer dünnen, gut haftenden, lötbadstabilen, elektrisch- leitfähigen Metallauflage von größter Wichtigkeit.

Es ist weiterhin bekannt, daß die Abscheidung von haftfesten Metallauflagen auf den üblichen Isolierbasismaterialien eine aufwendige Vorbehandlung erfordert. So müssen beispielsweise die Basisplatten aus glasmattenverstärkten Epoxidharzen oder papierverstärkten Phenolharzen zur Herstellung von Leiterplatten zunächst mit einer Haftvermittlerschicht versehen und anschließend mit einer oxidierenden Flüssigkeit, vorzugsweise Chromschwefelsäure, behandelt werden, bevor die so präparierten Platten mit ionischen oder kolloidalen Edelmetallösungen aktiviert, maskiert und in handelsüblichen Metallisierungsbädern metallisiert werden.

Abgesehen von der Vielstufigkeit dieser Methoden weist diese Technik den Nachteil auf, daß eingeschleppte Chromionen die Bäder irreversibel vergiften und daß die erhaltenen Leiterplatten unbefriedigende elektrische Eigenschaften zeigen.

Es ist daher bereits vorgeschlagen worden, die nichtleitenden Oberflächen von Substraten, beispielsweise Basisträger von Leiterplatten, ohne oxidative Vorbehandlung mit einer Lösung oder einem Lack einer Edelmetallaminkomplexbildung bzw. des Palladiumchlorids für die anschließende chemische Metallisierung zu aktivieren (vgl. z.B. DE-A 1 696 603 und DE-A 2 116 389, entsprechend US-A 3 560 257 bzw. US-A 4 248 632 sowie EP-A 53 279). Auf der letztgenannten Druckschrift beruht der erste Teil des Anspruchs 1. Bei der Herstellung der bekannten Leiterplatten wird beispielsweise ein Zinn-Palladium Hydrosol als Aktivator verwendet.

Diese an sich materialschonenden Aktivierungsverfahren konnten sich jedoch bislang in der Praxis nicht durchsetzen, da sie verhältnismäßig große Edelmetallmengen benötigen und die in der Elektronikindustrie geforderten hohen Abzugsfestigkeiten der Metallauflagen nicht erreichen. Aus diesem Grunde wird zumindest in der erstgenannten Patentpublikation eine zusätzliche Oberflächenbehandlung mit Ätzmittel empfohlen (vgl. Spalte 6, Zeile 48).

Es wurde nun gefunden, daß man diese Nachteile vermeiden und auf einfache Weise, d.h. ohne Ätzung und ohne Haftvermittlerschicht, mittels einer Semi- oder Volladditivtechnik zu hochwertigen Leiterplatten gelangt, wenn man als Basismaterial ein solches verwendet, dessen Oberfläche charakterisiert ist durch

a) ein flächenbezogenes spezifisches Gesamtporenvolumen von 0,015–0,045 $dm^3/m^2$

b) einen mittleren Porendurchmesser von 0,05–12,0 µm und

c) eine mittlere Porentiefe von 0,05–12,0 µm

und als Aktivatorsysteme solche auf der Basis organischer Verbindungen von Edelmetallen der 1. oder 8. Nebengruppe des periodischen Systems der Elemente verwendet.

Das bevorzugte Porenvolumen liegt zwischen 0,020 und 0,040 $dm^3/m^2$, insbesondere zwischen 0,023 und 0,038 $dm^3/m^2$.

Bevorzugte Porendurchmesser sind 0,05–5 µm, insbesondere 1–2 µm.

Bevorzugte Porentiefen sind 0,5–2,5 µm.

Im Vergleich zu ebenfalls bekannten "Semiadditiv-Methoden", die durch das Auflaminieren von galvanisch hergestellten Dünnschichtauflagen oder durch das chemische Abscheiden von Metallen mit Hil-

fe einer kautschukhaltigen Haftvermittlerauflage charakterisiert sind, zeichnet sich die Herstellung der neuen Leiterplatten durch einen geringeren Arbeitsaufwand sowie verbesserte mechanische, thermische und elektrische Eigenschaften des polymeren Basismaterials aus.

Das Verfahren zur Herstellung der erfindungsgemäßen Leiterplatten ist dadurch ausgezeichnet, daß man das Basismaterial mit der oben spezifizierten Oberflächenbeschaffenheit mit einem organometallischen Aktivatorsystem der angegebenen Art behandelt, gegebenenfalls mit einem Reduktionsmittel sensibilisiert, die so erhaltenen Halbzeuge in einem naßchemischen Metallisierungsbad ganzflächig oder partiell metallisiert und anschließend die Leiterplatten nach den bekannten Prinzipien der Semi- oder Volladditiv-Technik fertigstellt.

In einer besonderen Ausführung des Verfahrens werden zur Erhöhung der Prozeßsicherheit die so behandelten Leiterplattenbasismaterialien bei einer Temperatur von 50°C bis zum Zersetzungsbereich, vorzugsweise im Bereich der Erweichungstemperatur, getempert.

Bei den als Ausgangsmaterialien verwendeten metallisierten Basisplatten handelt es sich vor allem um beidseitig metallkaschierte, vorzugsweise unter Verwendung von Elektrolytkupferfolien kaschierte handelsübliche Plattenmaterialien für die Subtraktiv-Technik, die durch die Normgrößen FR-2, FR-3, FR-4, Fr-5, G-10 und G-11 charakterisiert sind und weiter unten näher beschrieben sind.

Zur Ablösung der Metallkaschierung sind wohl saure als auch neutrale und alkalische Redoxbäder geeignet. Beispielsweise seien salz- oder schwefelsäurehaltige Redoxsysteme auf Basis von $H_2O_2$, $ClO_3^-$ und $Fe^{3+}$ sowie ammoniakalkalische natriumchlorit- und ammoniumpersulfathaltige Redoxsysteme erwähnt. Auch andere Redoxsysteme, die eine Abätzung der Metallauflage bewirken, können zur Durchführung des Verfahrens eingesetzt werden, vorausgesetzt, daß die Kunststoffoberfläche vom eingesetzten Redoxbad nicht angegriffen wird. Aus diesem Grunde sollen die üblichen aggressiven Kunststoffbeizbäder auf der Basis von Chromschwefelsäure möglichst vermieden werden, zumal diese auch die physikalischen Eigenschaften des Trägermaterials beeinträchtigen.

Optimale Oberflächenstrukturen werden erzielt, wenn man von einem Plattenmaterial ausgeht, das mit galvanisch erzeugten Metallfolien kaschiert worden ist.

Solche Metallfolien weisen nämlich eine besondere Porosität auf, die beim Kaschieren auf den polymeren Trägerwerkstoff für die Erzeugung der speziellen Oberflächenbeschaffenheit der Basismaterialien maßgeblich verantwortlich ist.

Die Porositätbildung kann dadurch gefördert werden, daß man den Galvanisierungsbädern Komplexverbindungen auf der Basis von Antimon, Cadmium, Eisen, Selen und Tellur zusetzt oder nachträglich die Elektrolytfolie auf chemischem oder mechanischem Wege aufrauht.

Die Herstellung von solchen durch eine poröse Oberflächengestalt (Topografie) charakteriserten Metall(vorzugsweise Kupfer-)-folien ist vielfach in der Literatur beschrieben worden. In diesem Zusammenhang seien erwähnt: "Metalloberfläche" Band 31 (12), 563 (1977), Band 38 (10), 439 ff (1984) und Band 38 (3), 103 ff (1984) sowie folgende Patentliteratur DE-A 2 235 522, DE-A 2 249 796, DE-A 2 500 160, DE-B 1 496 748, US 3 220 897, US 3 328 275, US 3 580 010 und US 3 227 636. Gemäß Verfahren der letztgenannten US-Patentschrift erhält man poröse Metall(Kupfer)-Folien, deren poröse Seite eine besonders wirksame Metall/Metalloxid-Struktur aufweist.

Geeignete Metallfolien leiten sich grundsätzlich von allen gängigen galvanisch abscheidbaren Metallen ab, wie Co, Ni, Pt, Pd, Ag, Al und vor allem Au und insbesondere Cu sowie deren Mischungen (vgl. z.B. "Plating", 52, 228-232 (1965)).

Beispielsweise geht man bei der Herstellung der metallkaschierten Plattenmaterialien wie folgt vor:

Die mit Harzvorprodukt und Härter getränkten Glasmatten werden bei erhöhter Temperatur zwischen zwei porösen Metallfolien verpreßt. Dabei empfiehlt es sich, die Harzmasse im heißen Preßwerkzeug etwas verhärten zu lassen, bevor der ganze Schließdruck angewandt wird, damit das dünnflüssige Harz nicht seitlich ausgepreßt wird.

Nach dem Abbeizen der Metallkaschierung erhält man auf dem polymeren Trägerwerkstoff eine Oberflächenstruktur, die in ihren Dimensionen der des für die Erfindung zu verwendenden Basismaterials entspricht.

Das "flächenbezogene, spezifische Gesamtporenvolumen" ist das Produkt aus dem spezifischen Gesamtporenvolumen ($cm^3/g$) und der flächenbezogenen Masse ($g/m^2$) der Basismaterialien, d.h.

$[cm^3/g] \cdot [g/m^2] = [cm^3/m^2]$ bzw. $[10^{-3} \cdot m^3/^2]$

Die Definition des spezifischen Gesamtporenvolumens von Feststoffoberflächen findet man in Angew. Chem. 84. S. 331-336 (1972).

Unter "mittlerer Porentiefe" und "mittlerem Porendurchmesser" sind die Mittelwerte (unter Berücksichtigung der Gauß'chen Normalverteilung) der mit dem Rasterelektronenmikroskop ermittelten Porenabmessungen zu verstehen.

Bei den erfindungsgemäß zu verwendenden organischen Edelmetallverbindungen handelt es sich um bekannten Aktivatorsysteme. beispielsweise um Pd- und Pt-Komplexe von Dienen. polymeren Komplexbildnern und α,β-ungesättigten Ketonen. wie sie z.B. in DE-A 30 25 307, 31 50 985 und 33 24 767 beschrieben sind.

Bevorzugt sind organometallische Verbindungen, vorzugsweise π-Komplexverbindungen, die außer der zur Metallbindung erforderlichen Gruppe wenigstens eine weitere funktionelle Gruppe aufweisen. Solche Verbindungen sind bekannt und in DE-A 3 148 280 beschrieben.

Mit der weiteren funktionellen Gruppe wird eine sehr gute Haftfestigkeit auf der Substratoberfläche erreicht. wobei diese Haftfestigkeit auf eine chemische Reaktion mit der Substratoberfläche oder auf eine Adsorption zurückgehen kann.

Besonders geeignet für eine chemische Verankerung des Aktivators an der Substratoberfläche sind funktionelle Gruppen wie Carbonsäuregruppen, Carbonsäurehalogenidgruppen, Carbonsäureanhydridgruppen, Carbonestergruppen, Carbonamid- und Carbonimidgruppen, Aldehyd- und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige heterocyclische Reste, wie Chlortriazinyl-, -pyrazinyl-, -pyrimidinyl- oder -chinoxalinylgruppen, aktivierte Doppelbindungen, wie bei Vinylsulfonsäure- oder Acrylsäurederivaten, Aminogruppen, Hydroxylgruppen, Isocyanatgruppen, Olefingruppen und Acetylengruppen sowie Mercaptogruppen.

Besonders bevorzugt sind solche Edelmetallkomplexverbindungen, in denen die Liganden und die zu komplexierenden Ionen bzw. Moleküle in einer "Gast/Wirt"-Wechselbeziehung stehen.

Als selektive Komplexliganden kommen cyclische oder acyclische Verbindungen in Frage, die wegen ihrer chemischen und/oder physikalischen Beschaffenheit ein Wirtsmolekül sind oder in Gegenwart von zu komplexierenden ionogenen oder neutralen Verbindungen die zur Komplex- bzw. Adduktbildung erforderliche Form annehmen, wobei die polaren Bereiche in Gegenwart des zu komplexierenden Mediums zu diesem hinausgerichtet werden.

In der Literatur sind zahlreiche selektive Wirtsmoleküle, die mit den Alkali- oder Erdalkalikationen wie $Li^+$, $Na^+$, $K^+$, $Ca^{2+}$ oder $NH_4^+$ [vgl. E. Weber, "Kontakte" (Darmstadt) 1, (1981) und J.G. Schindler, "Bioelektrochemische Membranelektroden" S. 77-104, Walter de Gruyter Verlag, Berlin/New York (1983)] oder mit Schwermetallionen wie $Co^{2+}$, $Ni^{2+}$, $Fe^{3+}$, $Cd^{2+}$ und $Ag^+$ sowie mit Anionen wie $Cl^-$ und $SO_4^{2-}$ [vgl. vorstehend zitierte Arbeit von J.G. Schindler, S. 104-112] sowie mit den neutralen Liganden bzw. Verbindungen einen selektiven Gast-Wirtskomplex bilden können, beschrieben worden.

Zur Durchführung der Aktivierung eignen sich alle Wirtskomplexliganden, die in ihrer Kette Heteroatome (O, N und S) enthalten. Gut geeignet sind Kronenether, Cryptanden und Podanden oder deren Derivate sowie cyclische Peptide; weiterhin tetrahydrofuranhaltige, esterverknüpfte Makrolide und analoge Verbindungen auf der Basis von Heteroatomen wie S und N, die beispielsweise in biologischen Systemen als Transportregulatoren bekannt sind.

Eine Definition der Begriffe "Kronenether", "Cryptande" und "Podanden" kann den Übersichtsarbeiten F. Vögtle, "Kontakte" (Darmstadt) (1977) und (1978), E. Weber, "Kontakte" (Darmstadt) (1984) sowie Vögtle "Chemikerzeitung" 97, 600-610 (1973) entnommen werden.

Besonders bevorzugt werden substituierte bzw. unsubstituierte Wirtsliganden auf der Basis von cyclischen oder acyclischen Kronenethern, die in ihrem Ringsystem noch zusätzlich Heteroatome wie N und S enthalten können, eingesetzt. Solche Verbindungen sind in DE-A 2 842 862 bzw. EP-A 10 615 beschrieben und entsprechen z.B. den Formeln

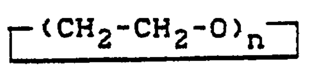

(n = 4-10) (I)

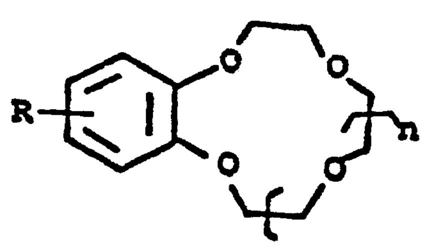

(II)

n = 0–4
R = Alkyl, Aryl, Halogen u.a.

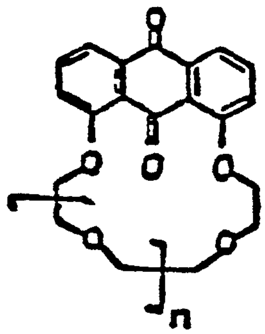

(III)

n = 0–4

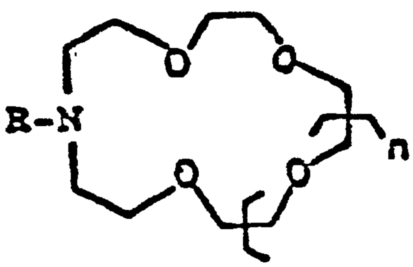

(IV)

n = 0–4

R = Alkyl oder Aryl; z.B. Methyl, Ethyl, Phenyl, Biphenyl, Phenylazophenyl u.a.

Bevorzugt sind die vorstehend genannten cyclischen Verbindungen.

Eine andere Variante der Durchführung des Aktivierungsverfahrens besteht darin, daß man die erwähnten Wirtsmoleküle in polymeren oder oligomeren Verbindungen kovalent einbaut und sie dann mit den gewünschten Aktivierungsmedien komplexiert. Solche oligomere oder polymere Systeme sind bekannt und werden beispielsweise in "Novel Polyurethanes with Macroheterocyclic (Crown-Ether) Structures in the Polymer Backbone", J.E. Herweh, J. of Polymer Science: Polymer Chemistry Edition, Vol. 21, 3101 (1983) beschrieben.

Der anorganische Teil der Wirt/Gast-Molekeln wird vorzugsweise

1. aus Verbindungen der Formel $Me^{n+}$ $E^{m+}$ $Hal_z^-$
worin Me für Wasserstoff-, Alkali- oder Erdalkaliatome bzw. Schwermetallatome (Fe, Co, Ni oder Cu) oder für $NH_4$, Hal für Halogen (vorzugsweise Cl und Br) und E für ein Edelmetallatom der 1. oder 8. Nebengruppe des Periodensystems (vorzugsweise Pt, Pd und Au) mit der Wertigkeit m bzw. n und der Koordinationszahl z steht, wobei z-m=n ist, oder
2. aus den Kationen, der besagten Elemente vorzugsweise $Ag^+$, $Cu^{2+}$ und $Cu^+$
oder vorzugsweise
3. aus nichtkomplexen Salzen dieser Elemente der Formel
$E^{m+}$ $Hal_p^-$
oder
4. aus üblichen Kolloidal-Systemen dieser Edelmetalle gebildet.

Bevorzugt anzuwendende Edelmetallverbindungen sind solche der Formel $H_2PdCl_4$, $Na_2(PdCl_2Br_2)$, $Na_2PdCl_4$, Ca $PdCl_4$, $Na_4(PtCl_6)$, $AgNO_3$, $HAuCl_4$, $CuCl_2$ und CuCl. Bevorzugt sind die Pd-Verbindungen.

Geeignete kolloidale Edelmetallsysteme leiten sich vor allem von den Metallen Pd, Pt, Au und Ag ab und sind beispielsweise in "Kunststoffgalvanisierung" von R. Weiner, Eugen G. Leuze Verlag, Saulgau/Württ. (1973), Seiten 180-209, beschrieben.

Die Herstellung der Aktivierungslösung kann durch Lösen des Wirtsmoleküls in einem geeigneten aprotischen Lösemittel mit Siedepunkten bei 80°C wie Perchlorethylen, 1,1,1-Trichlorethan, $CH_2Cl_2$, Petrolether oder Chloroform und Zugabe des Edelmetallsystems nach dem schon erwähnten Prinzip erfolgen.

Eine andere Möglichkeit zur Herstellung der Aktivierungssysteme ist, daß man die besagten Edelmetalle in einer wäßrigen Phase vorlegt und sie wiederum nach dem erwähnten Prinzip in eine organische Phase, die die komplexbildungsfähige Wirtsmoleküle enthalten, diffundieren bzw. komplexieren läßt, die organische Phase von der wäßrigen trennt, sie gegebenenfalls neutralwäscht, den so hergestellten Komplex durch Umkristallisation oder Eindampfen von dem Lösungsmittel befreit und dann in einem gewünschten flüssigen Medium für die Aktivierung einsetzt.

Die Aktivatoren können in Konzentrationsbereichen von 0,001 g/l (bezogen auf das Edelmetall) bis hin zur jeweiligen Löslichkeitsgrenze eingesetzt werden. Vorzugsweise arbeitet man mit 0,1 bis 3,0 g/l dieser Substanzen.

Dank ihrer hohen Lagerungsstabilität (keine Eintrübung der Lösungen - z.T. nach wochenlanger Lagerung) und ihrer starken Sorption im ultravioletten und/oder sichtbaren Spektralbereich, eignen sie sich hervorragend für die kontinuierliche Konzentrationsüberwachung mit einem Fotometer.

Im übrigen können die Sorptionseigenschaften der erfindungsgemäß zu verwendenden Komplexverbindungen durch Einführung spezieller Substituenten (insbesondere $-NO_2$, $-NR_3$, $-SO_3H$ und -CN) noch erhöht werden.

Zur Erhöhung der Abzugsfestigkeit der Aktivator- bzw. Metallauflage können die besagten Wirtsmoleküle zusätzlich mit einer weiteren funktionellen Gruppe versehen werden.

Besonders geeignet für eine chemische Verankerung des Aktivators an der Substratoberfläche sind funktionelle Gruppen wie Carbonsäuregruppen, Carbonsäurehalogenidgruppen, Carbonsäureanhydridgruppen, Carbonestergruppen, Carbonamid- und Carbonimidgruppen, Aldehyd- und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige, heterocyclische Reste, wie Chlortriazinyl-, pyrazinyl-, pyrimidinyl- oder -chinoxalinylgruppen, aktivierte Doppelbindungen, wie bei Vinylsulfonsäure- oder Acrylsäurederivaten, Aminogruppen, Hydroxylgruppen, Isocyanatgruppen, Olefingruppen und Acetylengruppen sowie Mercapto- oder Alkenylreste ab $C_8$, insbesondere Olein-, Linolein-, Stearin- oder Palmitingruppen.

Wenn keine Verankerung durch eine chemische Reaktion stattfindet, kann die Haftfestigkeit auch durch Sorption der organometallischen Aktivatoren an der Substratoberfläche bewirkt werden, wobei als Ursachen für die Sorption z.B. Wasserstoffbrückenbindungen oder van der Waalssche-Kräfte in Frage kommen.

Es ist zweckmäßig, die die Adsorption hervorrufenden funktionellen Gruppen auf das jeweilige Substrat abzustimmen. So verbessern z.B. langkettige Alkyl- oder Alkenyl-Gruppen im Aktivatormolekül die Haftfestigkeit auf Substraten aus Polyethylen oder Polypropylen. Zur Metallisierung von Gegenständen auf Polyamid- oder Polyesterbasis sind dagegen Aktivatoren mit beispielsweise zusätzlichen Carbonyl- oder Sulfongruppen besonders günstig.

Besonders geeignet für eine Verankerung des Aktivators an der Substratoberfläche durch Adsorption sind funktionelle Gruppen wie Carbonsäuregruppen, Carbonsäureanhydridgruppen.

Bei der praktischen Durchführung der Aktivierung geht man im allgemeinen so vor, daß man die zu metallisierenden Basisträger mit einer Lösung des selektiven Metallkomplexes in einem geeigneten organischen Lösungsmittel benetzt, das Lösungsmittel entfernt und gegebenenfalls mit einem geeigneten Reduktionsmittel sensibilisiert. Danach kann der so vorbehandelte Träger in einem üblichen Metallisierungsbad metallisiert werden.

Als Reduktionsmittel für die Sensibilisierung eignen sich Aminoborane, Alkalihypophosphite, Alkylborhydride, Hydrazinhydrat und Formalin. Das Benetzen der Substrate kann durch Besprühen, Bedrucken, Tränken oder Imprägnieren erfolgen.

Um die Haftung der Metallauflage an der Trägeroberfläche zu erhöhen, werden solche Lösungsmittel oder Lösungsmittelgemische, die zu einer geringen Anlösung oder Anquellung der zu metallisierenden kunststoffoberfläche führen, besonders bevorzugt eingesetzt.

Zur Durchführung dieses Verfahrens sind aprotische Lösemittel wie 1,1,1-Trichlorethan, Methylenchlorid, Trichlormethan, Perchlorethylen, Toluol besonders gut geeignet. Erfindungsgemäße Aktivierungssysteme, die noch zusätzlich hydrolysierbare metallorganische Verbindungen des Titans, Aluminiums, Zirkons, Siliziums oder Tantals in Mengen von 0,1-20, vorzugsweise 0,1-3, besonders bevorzugt 0,1-2 g/l enthalten, werden bevorzugt eingesetzt.

Die Entfernung der Lösungsmittel von den benetzten Trägern erfolgt einfach durch Verdampfen oder bei höher siedenden Verbindungen durch Extraktion.

Nach einer bevorzugten Verfahrensvariante werden die organischen Aktivierungsbäder mit einem Fotometer als Detektor überwacht.

Eine ganz besonders bevorzugte Ausführungsform der Aktivierung besteht darin, daß die Reduktion im Metallisierungsbad gleich mit dem Reduktionsmittel der stromlosen Metallisierung durchgeführt wird.

Diese Ausführungsform ist ganz besonders für aminboranhaltige Nickelbäder oder formalinhaltige Kupferbäder geeignet.

Als in dem Verfahren zur Herstellung der erfindungsgemäßen Leiterplatten einsetzbare Metallisierungsbäder kommen handelsübliche heiße und kalte Bäder von Nickelsalzen, Cobaltsalzen, Kupfersalzen, Gold- und Silbersalzen oder deren Gemische in Betracht, wobei die Cu-Bäder ganz besonders zu bevorzugen sind.

Für eine gegebenenfalls durchzuführende galvanische Verstärkung kommen folgende Metalle in Frage: Ni, Co, Cu, Ag,. Al, Cr und Au. Bevorzugt sind Cu, Au und Ni, ganz besonders bevorzugt ist Cu.

Um gegebenenfalls die Haftung der auf der in der Erfindung verwendeten Kunststoffoberfläche abgeschiedenen Metallauflage zu erhöhen bzw. um eine 100 %ige Prozeßsicherheit zu gewährleisten, kann eine Temperung vorgenommen werden. Bemerkenswert ist, daß die Temperung überraschenderweise im

Gegensatz zu den anderen Verfahren (siehe beispielsweise DE-A 32 42 162 und US 4 327 126) an bereits endgehärteten Platten vorgenommen wird, was das Verfahren universell anwendbar, d.h. von der Lagerzeit des Trägermaterials unabhängig macht.

Die Temperungstemperatur kann im breiten Bereich von 50°C bis zum jeweiligen Zersetzungsbereich des polymeren Basismaterials variiert werden, wobei für das "FR-4"-Material die Temperaturen von 125°C-180°C insbesondere der Erweichungsbereich des polymeren Basismaterials und für das FR-2 und FR-3 die Temperaturen von 80°C-130°C insbesondere der Erweichungsbereich zu bevorzugen sind. Die Temperungszeiten können zwischen 5 Minuten bis 10 Stunden variiert werden, wobei die Zeiten 10 bis 60 Minuten besonders zu bevorzugen sind. Um einen Abbau des Basismaterials zu vermeiden, kann die Temperung unter Inertgas vorgenommen werden.

Selbstverständlich kann die Temperung auch nach der galvanischen oder chemischen Verstärkung der Metallauflage auf die gewünschte Schichtdicke vorgenommen werden.

Bevorzugte Kunststoffe zur Herstellung der Basisplatten sind härtbare duroplastische Materialien (englisch: thermosetting resins) wie Phenol-, Epoxid-, Melamin- und Polyesterharze, wobei die Phenol- bzw. Epoxidharze (FR-2, FR-3, FR-4 und FR-5) ganz besonders bevorzugt eingesetzt werden.

Die duroplastischen Substrate können mit Verstärkungsmaterialien, wie mit Glas-, Mineral-, Kohle- und Aramid-Fasern bzw. -Matten und deren Gemische untereinander, verstärkt werden.

Die aus diesen Basismaterialien durch Aktivieren und gegebenenfalls Anbringen von Bohrlöchern erhältlichen sogenannte Halbzeuge, sowie die daraus hergestellten Leiterplatten weisen überraschenderweise folgende gute Eigenschaften auf:

1. Sie sind an der Luft gegenüber Feuchtigkeit, Witterungs- und Wärmeeinflüsse stabil.
2. Ihre Aktivatorauflage ist nicht während des Aufbringens bzw. des Entwickelns von Fotoresistauflagen von der Oberfläche entfernbar. Sie läßt sich problemlos mit Hilfe von bekannten Oberflächenanalysemethoden, wie ESCA, nachweisen.
3. Die Abzugsfestigkeit der Metallauflagen nach DIN 53 494 beträgt mindestens 22,5 vorzugsweise jedoch 30-35 N/25 mm und in vielen Fällen größer als 50 N/25 mm.
4. Bei der Sensibilisierungs bzw. Metallisierung tritt keine Vergiftung der Metallisierungs- oder Sensibilisierungsbäder ein.

Diese Vorzüge weisen solche Halbzeuge bzw. Leiterplatten, die ausgehend von mit nichtelektrolytisch abgeschiedenen Metallfolien kaschierten Basisträgern für die Additivtechnik hergestellt werden, nicht oder in wesentlich geringerem Maße auf.

Die Oberflächen der "Halbzeuge" können mit einer leicht abziehbaren Alu- oder Kunststoff-Folie versehen werden. Besonders die Alufolie dient als Bohrhilfe und schützt die Substratoberfläche von äußeren Einflüssen.

Die erfindungsgemäßen Leiterplatten sind zur Herstellung von ein- oder mehrlagigen gedruckten Schaltungen aller Art geeignet. Vorzugsweise werden durchkontaktierte gedruckte Schaltungen hergestellt.

## Beispiel 1

Eine handelsübliche beidseitig mit Elektrolytkupfer beschichtete, glasmattenverstärkte Epoxidharzplatte (FR-4) für die Subtraktiv-Technik, z.B. der Firma Isola AG, Düren (Germany), wird gebohrt und dann entstaubt. Diese Platte wird durch Abätzen in einer alkalischen 15,7%igen Natriumchloritlösung (pH~12) von der Cu-Auflage befreit, in 2%iger $NaHSO_3$-Lösung entgiftet, mit $H_2O$ und dann mit Methanol gewaschen, getrocknet. Man bekommt eine an der Oberfläche poröse Platte mit einem flächenbezogenen spezifischen Gesamtporenvolumen von ~0,028 dm³/m² und einem mittleren Porendurchmesser von 2,0 µm bzw. einer mittleren Porentiefe von 2,5 µm. Sie wird anschließend 5 Minuten in einer Lösung bestehend aus 1,58 g 4-Cyclohexen-1,2-dicarbonsäureanhydrid-palladium-II-chlorid, 1500 ml nachgereinigtem $CH_2Cl_2$ und 2,15 g Titansäuretetrabutylester aktiviert, getrocknet und dann in einer Lösung bestehend aus 750 ml $H_2O_{dest.}$, 7,5 g Dimethylaminboran und 1,75 g NaOH (fest) sensibilisiert, in einem handelsüblichen Verkupferungsbad verkupfert, mit $H_2O_{dest.}$ gewaschen, im Trockenschrank bei 178°C getempert. Die so mit einer gut haftenden, elektrisch leitenden Metallauflage versehene Probe wird mit einer Siebdruckmaske auf Basis vom Polybutadien, welche freie rasterförmige Bahnen von etwa 100 µm aufweist, bedeckt und dann die freie Metalloberfläche mit galvanischem Kupfer auf zirka 45 µm verstärkt. Nun wird der Probekörper in Methylethylketon von der Maske befreit und die darunterliegende auf chemischem Wege abgeschiedene Cu-Auflage in einer Lösung aus 500 ml $H_2O_{dest.}$, 8,5 ml HCl (reinst 37%ig) und 18,5 ml $H_2O_2$ abgeätzt.

Man bekommt eine durchkontaktierte, elektrische Leiterplatte mit zirka 100 µm breiten und 44 µm starken Leiterbahnen. Die Metallauflage haftet an der Substratoberfläche so gut, daß sie trotz einer 25-minütigen Wärmebelastung bei 225°C nicht von der Substratoberfläche zu entfernen ist. Diese Metallauflage läßt sich nach herkömmlichen Methoden löten.

Beispiel 2

Eine in Europa-Format zurechtgeschnittene beidseitig Cu-kaschierte Epoxidharzplatte aus FR-4-Material wird in einer Redox-Lösung bestehend aus 50 ml HCl (37%ig), 60 ml $H_2O_2$ und 500 ml $H_2O$ von der Cu-Auflage befreit. Man bekommt eine oberflächenporöse Platte mit einem flächenbezogenen spezifischen Gesamtporenvolumen von 0,024 $dm^3/m^2$ und einem mittleren Porendurchmesser von 2,5 µm bzw. einer maximalen. Porentiefe von 3,0 µm. Diese Platte wird in einer Lösung bestehend aus 200 ml Aceton, 800 ml $H_2O_{dest.}$ und 0,8 g Mesityloxidpalladiumchlorid im Verlaufe von 3 Minuten aktiviert. Danach wird die Platte 5 Minuten in einer Lösung von 5 g Dimethylaminboran in einem 1 l $H_2O$/Methanol-Gemisch (50 : 50 Vol.-%) behandelt. Nach kurzem Spülen werden in einem chemischen Cu-Bad eine zirka 0,5 µm starke Cu-Auflage aufgetragen. Die chemisch verkupferte Platte wird darauf 1 h bei 160°C getempert und nach Beispiel 1 galvanisch verstärkt und dann von dem Rest-Cu befreit. Man erhält eine lötbare Leiterplatte mit einer sehr guten Metallhaftung.

Beispiel 3

Eine in Europa-Format zurechtgeschnittene beidseitig Cu-kaschierte Epoxidharzplatte aus Fr-2-Material wird nach Beispiel 1 von der Cu-Auflage befreit. Man bekommt eine oberflächenporöse Platte mit einem flächenbezogenen spezifischen Gesamtporenvolumen von 0,020 $dm^3/m^2$. Diese Platte wird nach Beispiel 1 metallisiert. 14 min. bei 150°C, 25 min. bei 120°C getempert und dann nach Beispiel 1 weiter verarbeitet. Man bekommt eine Leiterplatte mit guter Metallhaftung. Diese Platte ist nach herkömmlichen Methoden lötbar.

**Patentansprüche**

1. Elektrische Leiterplatten bestehend aus dem Basismaterial und dem naßchemisch unter Verwendung von Aktivatorsystemen nach den Prinzipien der Semi- oder Volladditivtechnik aufgebrachten Leiterbild, wobei die durch ein flächenbezogenes spezifisches Gesamtporenvolumen von 0,015–0,045 $dm^3/m^2$, einen mittleren Porendurchmesser von 0,05–12,0 µm und eine mittlere Porentiefe von 0,05–12,0 µm charakterisierte Oberfläche des Basismaterials durch chemische oder elektrogalvanische Ablösung der mit einer elektrolytisch erzeugten Metallfolie versehenen Kaschierung des Basismaterials erhalten wurde, dadurch gekennzeichnet, daß die Aktivatoren organische Verbindungen von Edelmetallen der 1. oder 8. Nebengruppe des periodischen Systems der Elemente sind.

2. Elektrische Leiterplatten gemäß Anspruch 1, dadurch gekennzeichnet, daß als Edelmetallverbindungen solche von Pt, Pd, Au, Ag und/oder Rh verwendet werden.

3. Elektrische Leiterplatten gemäß Anspruch 1, dadurch gekennzeichnet, daß
a) das Porenvolumen 0,20-0,40 $dm^3/m^2$,
b) der Porendurchmesser 1-2 µm und
c) die Porentiefe 0,5-2,5 µm betragen.

4. Elektrische Leiterplatten nach Anspruch 1, dadurch gekennzeichnet, daß man zur Aktivierung eine Gast/ Wirt-Komplexverbindung der genannten Edelmetalle verwendet.

5. Elektrische Leiterplatten nach Anspruch 1, dadurch gekennzeichnet, daß man zur Aktivierung organometallische Komplex-Verbindungen verwendet, die außer der zur Metallbindung erforderlichen Gruppe wenigstens eine weitere funktionelle Gruppe zur Verbesserung der Haftfestigkeit auf den Substratoberflächen aufweisen.

**Claims**

1. Electrical printed circuit boards consisting of the base material and the conductor pattern applied by wet chemical means using activator systems according to the principles of the semi or fully additive technique, the surface of the base material, which is characterized by a specific total pore volume per unit area of 0.015–0.045 $dm^3/m^2$, a mean pore diameter of 0.05–12.0 µm and a mean pore depth of 0.05–12.0 µm, being obtained by chemically or by electrochemically removing the base material cladding provided with an electrolytically produced metal foil, characterized in that the activators are organic compounds of precious metals of the 1st or 8th sub-group of the periodic system of elements.

2. Electrical printed circuit boards according to Claim 1, characterized in that as precious metal compounds those of Pt, Pd, Au, Ag and/or Rh are used.

3. Electrical printed circuit boards according to Claim 1, characterized in that
a) the pore volume is 0.20–0.40 $dm^3/m^2$,
b) the pore diameter is 1–2 µm and
c) the pore depth is 0.5–2.5 µm.

4. Electrical printed circuit boards according to Claim 1, characterized in that a guest/host complex compound of the said precious metals is used for the activation.

5. Electrical printed circuit boards according to Claim 1, characterized in that for the activation organometallic complex compounds are used which, in addition to the group necessary for the metal bonding,

have at least one further functional group for improving the strength of adhesion to the substrate surfaces.

**Revendications**

1. Plaques de circuits imprimés constituées du matériau de base et du placage métallique sélectif appliqué chimiquement par voie humide en utilisant des systèmes activateurs selon les principes de la technique semi-additive ou entièrement additive, la surface du matériau de base caractérisée par un volume specifique total des pores par unité de surface de 0,015 à 0,045 $dm^3/m^2$, un diamètre moyen des pores de 0,05 à 12,0 µm et une profondeur moyenne des pores de 0,05 à 12,0 µm ayant été obtenue par dissolution chimique ou galvanique du placage de matériau de base muni d'une feuille métallique produite par voie électrolytique, caractérisées en ce que les activateurs sont des composés organiques de métaux nobles du premier ou du huitième sous-groupe du Système Périodique des Eléments.

2. Plaques de circuits imprimés suivant la revendication 1, caractérisées en ce qu'on utilise comme composés de métaux nobles des composés de Pt, Pd, Au, Ag et/ou Rh.

3. Plaques de circuits imprimés suivant la revendication 1, caractérisées en ce que

a) le volume des pores est de 0,20 à 0,40 $dm^3/m^2$,

b) le diamètre des pores est de 1 à 2 µm et

c) la profondeur des pores est de 0,5 à 2,5 µm.

4. Plaques de circuits imprimés suivant la revendication 1, caractérisées en ce qu'on utilise pour l'activation un composé complexe du type inclus/incluant des métaux nobles mentionnés.

5. Plaques de circuits imprimés suivant la revendication 1, caractérisées en ce qu'on utilise pour l'activation des composés organométalliques complexes qui présentent, en plus du groupe nécessaire à la liaison métallique, au moins un autre groupe fonctionnel servant à améliorer la résistance d'adhérence aux surfaces de substrats.